# EUROPEAN PATENT SPECIFICATION

(11) **EP 1 241 507 B1**
(45) Date of publication and mention of the grant of the patent: **04.05.2005**
(21) Application number: 02005406.0
(22) Date of filing: 08.03.2002
(51) Int. Cl.: G02B 26/02

(54) **An electrostatically-controlled optical micro-shutter with non-transparent fixed electrode**
Elektrostatisch gesteuerter optischer Mikroverschluss mit undurchsichtiger fester Elektrode
Micro-obturateur optique à commande électrostatique avec électrode fixe non-transparente

(30) Priority: 16.03.2001 IT TO20010250
(43) Date of publication of application: 18.09.2002
(73) Proprietor: C.R.F. Società Consortile per Azioni, 10043 Orbassano (Torino) (IT)
(72) Inventor: Pizzi, Marco, 10100 Torino (IT); Koniachkine, Valerian, 63017 Novosibisk 117 (RU)
(74) Representative: Notaro, Giancarlo

(56) References cited:
- WO-A-01/65302
- WO-A-80/00103
- US-A- 4 786 149
- US-A- 5 233 459
- US-A- 5 781 331
- PATENT ABSTRACTS OF JAPAN vol. 1999, no. 11, 30 September 1999 (1999-09-30) & JP 11 167078 A (NIKON CORP), 22 June 1999 (1999-06-22)

## Description

The present invention concerns electrostatically-controlled optical micro-shutter devices of the type that include:
a substrate, composed of a lamina of transparent material,
a first electrode, composed of a film of conductive material applied to one face of the lamina forming the substrate,
a transparent dielectric layer, applied over the film forming the first electrode, and
a mobile petal including a thin film of conductive material, constituting a second electrode, with one extremity connected to the dielectric layer and capable of moving, due to the electrostatic attraction deriving from the application of a voltage difference between the first electrode and the second electrode, from a rolled-up rest condition where it does not obstruct the passage of light through the substrate, to a rolled-out condition over the top of the dielectric layer, where the passage of light is interrupted.

An optical micro-shutter device of the above-illustrated type is described, for example, in European patent application EP-A-1 008 885 presented by the same applicant. Micro-shutter devices are also disclosed in WO-A-8 000 103, US-A-4 786 149, US-A-5 781 331 and JP-A-11 167 078.

Until now, the first electrode in optical micro-shutters of this type has had to be realized via a film of conductive material that is transparent to light. In fact, on one hand this film must allow light to pass when the micro-shutter petal is in its rolled-up rest condition, but on the other, this film must function as an electrode to attract the petal over the dielectric layer when the micro-shutter has to be shut. Normally, the said first electrode is realized using a material such as ITO (indium tin oxide) that does indeed have the characteristic of being transparent, whilst also being able to conduct electrical current. The inconvenience of this solution lies in the high cost of this material.

The object of this invention it to realize an optical micro-shutter possessing all of the above-indicated characteristics and that is also characterized by a simple and economic manufacturing structure.

In order to achieve this objective, the subject of the invention is an optical micro-shutter device possessing all of the above-indicated characteristics and which is also characterized in that said first electrode is composed of a film of conductive material that is not transparent to light and that has at least one opening for the passage of light.

In a preferred form of embodiment, the said film presents a substantially central aperture, which covers the greater part of the area occupied by the said first electrode, except for a peripheral border.

Thanks to the aforesaid characteristics, since light can pass through central aperture of the metal film when the petal is in its rolled-up rest condition, the first electrode can be realized using any non-transparent metallic material.

Further characteristics and advantages of the invention will become clear from the description that follows, supplied merely as a non limitative example, and with reference to the enclosed drawings where:
Figure 1 is a partial, perspective view of an array of optical micro-shutters in accordance with the invention,
Figure 2 is a partial cross-section view along the II-II line in Figure 1.

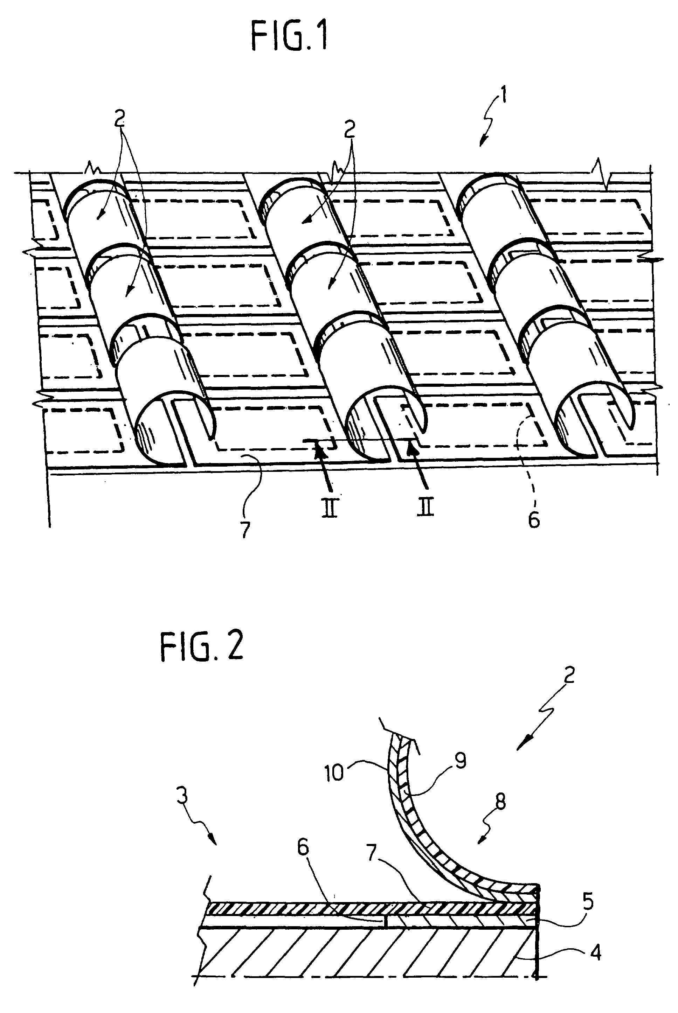

Figure 1 illustrates an array 1 composed of a number of micro-shutters 2 in accordance with the invention and ordered in rows and columns. Each of the micro-shutters 2 has a fixed support 3 including a substrate 4 composed of a lamina in glass or a light-transparent plastic that is a few millimetres or centimetres thick (see Figure 2). A layer 5 of a conductive material that is not light transparent, of a metallic material for example, is created on surface of the substrate 4 via evaporation, spin-coating, silkscreen printing or dipping. The metallic film 5 has a central aperture 6 that essentially covers the greater part of its extension, for which the metallic material in reality forms a peripheral border around the aperture 6. The thickness of the film 5, which constitutes the first electrode, can be in the order of a few tens or hundreds of nanometres. The conductive layer 5 is isolated with a layer 7 of light-transparent dielectric or ferroelectric material, the thickness of which can vary from 0.1 micrometers to a few tens of micrometers. This layer can be obtained via silk-screen printing, spin-coating or dipping. Reference number 8 indicates the mobile part of the device, which is composed of a petal including a dielectric film 9 a few microns thick, on which a metallic layer 10 is deposited on the side facing the dielectric layer 7. An elastic film 9 is used that is rolled up when in the un-deformed condition, as can be seen in Figure 1, this condition corresponding to the micro-shutter 2 being in the open state where, thanks to the transparency of the plate 4 and the dielectric layer 7, as well as the opening 6 in the electrode 5, the passage of light through the device is possible. The application of an electrical voltage between the two electrodes 5 and 10 generates an electrostatic effect causing adhesion of the layer 10 to the dielectric layer 7. The petal 8 thus unrolls over the fixed support 3, preventing light from passing through the window.

Arrangements of the above type can be utilized, for example, to realize any kind of display. The presence of the aperture 6 in each conductive film 5 allows the film to be produced using low-cost metallic materials. Naturally, for the purposes of allowing the passage of light in the micro-shutter open condition, it would be possible to provide multiple apertures in correspondence to each micro-shutter, however arranged or shaped.

Naturally, the principle of the invention being understood, the constructional details and forms of embodiment could be extensively changed with respect to that described and illustrated, by way of example, without leaving the scope of this invention.

For example, the mobile part of the micro-shutter could have a different shape and could be drawn, always by electrostatic effect, towards the open condition by an additional electrode. In addition, the substrate 4 could also be made of a non-transparent material and include an aperture for the passage of light.

## Claims

1. An electrostatically controlled optical micro-shutter device comprising:
a substrate (4) composed of a lamina of light-transparent material,
a first electrode (5) composed of a film of conductive material applied to one face of the lamina (4) forming the substrate,
a transparent dielectric layer (7) applied over the film (5) forming the first electrode, and
a mobile petal (8) including a thin film of conductive material (10) constituting a second electrode, with one extremity connected to the dielectric layer (7) and capable of moving, due to the electrostatic attraction deriving from the application of a voltage difference between the first electrode (5) and the second electrode (10), from a rolled-up rest condition where it does not obstruct the passage of light through the substrate, to an unrolled condition over the top of the dielectric layer (7), where the passage of light is interrupted,
**characterized in that** the said first electrode is composed of a film of non-transparent conductive material, having at least one aperture for the passage of light when the mobile petal (8) is in the rolled-up rest condition

2. A micro-shutter device according to Claim 1, **characterized in that** the film constituting the first electrode (5) has a central opening that occupies the greater part of the area of the substrate, said first electrode defining a peripheral border that surrounds the aperture.

3. A micro-shutter device according to Claim 1, **characterized in that** the said first electrode includes a number of apertures of any arrangement and shape.

4. An array of optical micro-shutters, **characterized in that** it includes a number of optical micro-shutter devices according to any of the previous Claims.

## Patentansprüche

1. Elektrostatisch gesteuerte optische Mikroverschlußvorrichtung, die folgendes aufweist:
ein Substrat (4), das aus einer Lage eines lichtdurchlässigen Materials besteht,
eine erste Elektrode (5), die aus einem Film eines leitenden Materials besteht, das auf eine Seite der das Substrat bildenden Schicht (4) aufgebracht ist,
eine transparente dielektrische Schicht (7), die über dem die erste Elektrode bildenden Film (5) aufgebracht ist, und
ein bewegliches Blatt (8), welches einen dünnen Film eines leitenden Materials (10) aufweist, der eine zweite Elektrode bildet, wobei ein Rand mit der dielektrischen Schicht (7) verbunden ist und in der Lage ist, sich aufgrund einer elektrostatischen Anziehung, die von dem Anlegen eines Spannungsunterschiedes zwischen der ersten Elektrode (5) und der zweiten Elektrode (10) herrührt, von einer aufgerollten Ruhestellung, in welcher sie nicht den Durchgang von Licht durch das Substrat behindert, in eine über das obere Ende der dielektrischen Schicht (7) abgerollte Stellung zu bewegen, in welcher der Durchgang von Licht unterbrochen ist,
**dadurch gekennzeichnet, dass** die erste Elektrode aus einem Film von nichttransparentem leitenden Material besteht, das wenigstens eine Öffnung für den Durchgang von Licht aufweist, wenn das bewegliche Blatt (8) sich in der aufgerollten Ruhestellung befindet.

2. Mikroverschlußvorrichtung nach Anspruch 1, **dadurch gekennzeichnet, dass** der die erste Elektrode (5) bildende Film eine zentrale Öffnung aufweist, die den größeren Teil der Fläche des Substrats belegt, wobei die erste Elektrode einen Umfangsrand definiert, der die Öffnung umgibt.

3. Mikroverschlußvorrichtung nach Anspruch 1, **dadurch gekennzeichnet, dass** die erste Elektrode eine Anzahl von Öffnungen von irgendeiner Anordnung und Form aufweist.

4. Anreihung von optischen Mikroverschlüssen, **dadurch gekennzeichnet, dass** sie eine Anzahl von Mikroverschlußvorrichtungen nach einem der vorgehenden Ansprüche aufweist.

## Revendications

1. Dispositif micro-obturateur optique à commande électrostatique comprenant :
un substrat (4) composé d'un feuillet d'un matériau transparent à la lumière,
une première électrode (5) composée d'un film d'un matériau conducteur appliqué à une face du feuillet (4) formant le substrat,
une couche diélectrique transparente (7) appliquée sur le film (5) formant la première électrode, et
un pétale mobile (8) comprenant un film mince d'un matériau conducteur (10) constituant une deuxième électrode, avec une extrémité reliée à la couche diélectrique (7) et capable de se déplacer, en raison de l'attraction électrostatique découlant de l'application d'une différence de tension entre la première électrode (5) et la deuxième électrode (10), à partir d'une condition de repos enroulée dans laquelle il n'obstrue pas le passage de la lumière à travers le substrat, à une condition déroulée sur le dessus de la couche diélectrique (7), dans laquelle le passage de la lumière est interrompu,
**caractérisé en ce que** ladite première électrode est composée d'un film d'un matériau conducteur non-transparent, comportant au moins une ouverture pour le passage de la lumière, lorsque le pétale mobile (8) est dans la condition de repos enroulée.

2. Dispositif micro-obturateur selon la revendication 1, **caractérisé en ce que** le film constituant la première électrode (5) possède une ouverture centrale qui occupe la plus grande partie de la superficie du substrat, ladite première électrode définissant une bordure périphérique qui entoure l'ouverture.

3. Dispositif micro-obturateur selon la revendication 1, **caractérisé en ce que** ladite première électrode comprend un certain nombre d'ouvertures présentant une configuration et une forme quelconques.

4. Groupe de micro-obturateurs optiques, **caractérisé en ce qu'**il comprend un certain nombre de dispositifs micro-obturateurs optiques selon l'une quelconque des revendications précédentes.
